# EUROPÄISCHE PATENTSCHRIFT

(11) **EP 3 206 039 B1**
(45) Veröffentlichungstag und Bekanntmachung des Hinweises auf die Patenterteilung: **04.01.2023**
(21) Anmeldenummer: 17150675.1
(22) Anmeldetag: 09.01.2017
(51) Int. Cl.: G01R 31/52, G01R 31/58, G01R 27/00, H02H 3/12

(54) **VERFAHREN ZUM ERKENNEN EINER UNTERBRECHUNG EINES AKTIVEN LEITERS IN EINEM UNGEERDETEN GLEICHSPANNUNGS-STROMVERSORGUNGSSYSTEM**
METHOD FOR DETECTING AN INTERRUPTION OF AN ACTIVE CONDUCTOR IN AN UNEARTHED DIRECT CURRENT SUPPLY SYSTEM
PROCÉDÉ DE RECONNAISSANCE D'UNE PANNE D'UN CONDUCTEUR ACTIF DANS UN SYSTÈME D'ALIMENTATION ÉLECTRIQUE À COURANT CONTINU NON MIS À LA TERRE

(30) Priorität: 13.01.2016 DE 102016200309
(43) Veröffentlichungstag der Anmeldung: 16.08.2017
(73) Patentinhaber: Bender GmbH & Co. KG, 35305 Grünberg (DE)
(72) Erfinder: HACKL, Dieter, 35463 Fernwald (DE); MACHT, Burkhard, 35410 Hungen (DE)
(74) Vertreter: advotec.

(56) Entgegenhaltungen:
- EP-A1- 1 586 910
- DE-A1- 19 621 567
- DE-A1- 19 826 410
- DE-T2- 69 637 279
- US-A- 4 638 245
- US-A- 4 837 519
- US-A- 4 929 901
- US-A- 5 818 236

## Beschreibung

Die Erfindung betrifft ein Verfahren zum Erkennen einer Unterbrechung eines aktiven Leiters in einem ungeerdeten Gleichspannungs-Stromversorgungssystem.

Für die Versorgung von elektrischen Betriebsmitteln (Verbrauchern) kommt bei erhöhten Anforderungen an die Betriebs-, Brand- und Berührungssicherheit die Netzform eines ungeerdeten Stromversorgungssystems zum Einsatz. Diese Netzform wird auch als isoliertes Netz oder IT-Stromversorgungssystem (frz. Isolé Terre - IT) bezeichnet. Bei dieser Art des Stromversorgungssystems sind die aktiven Teile von dem Erdpotenzial - gegenüber "Erde" - getrennt. Der Vorteil dieser Netze liegt darin, dass bei einem ersten Isolationsfehler, wie beispielsweise einem Erdschluss oder einem Körperschluss, das IT-Stromversorgungssystem weiter betrieben werden kann, da sich wegen des im Idealfall unendlich großen Impedanzwertes zwischen den aktiven Leitern (Außenleiter und gegebenenfalls ein mitgeführter Neutralleiter) des Netzes und Erde in diesem ersten Fehlerfall kein geschlossener (Fehler-)Stromkreis ausbilden kann.

Durch die inhärente Sicherheit des IT-Stromversorgungssystems kann somit eine kontinuierliche Stromversorgung der an das IT-Stromversorgungssystem angeschlossenen Betriebsmittel, bzw. der von dem IT-Stromversorgungssystem gespeisten Verbraucher, auch dann gewährleistet werden, wenn ein erster Isolationsfehler auftritt.

Aus der US 4,837,519 A sind eine Vorrichtung und ein Verfahren zur Erkennung eines durch einen Erdschluss verursachten Fehlerstroms in einem ungeerdeten DC-Stromversorgungssystem bekannt, an das individuelle Lasten angeschlossen sind. Um den Fehlerstrom sicher detektieren zu können, taktet ein Unterbrecherschaltkreis diesen Fehlerstromkreis und synchronisiert die Stromsensoren. Allerdings scheint hier der schaltungstechnische Aufwand recht hoch zu sein.

Weiter zeigt die Offenlegungsschrift DE 198 26 410 A1 ein Verfahren und eine Einrichtung zur Isolations- und Fehlerstromüberwachung. Als Maß für den resistiven Fehlerstrom wird das Produkt zwischen der Amplitude des erfassten Wechselstromanteils des Differenzstroms und dem Kosinus des Phasenwinkels zwischen Wechselstromanteil und Netzwechselspannung in abgeschaltetem Zustand des Netzes gebildet. Durch die Unterscheidung von resistiven Fehlerströmen und kapazitiven Ableitströmen ist das Verfahren auch in ausgedehnten Wechselstromnetzen einsetzbar.

Die Patentschrift DE 696 37 279 T2 beschreibt ein Fehlerverwaltungssystem/Störungsmanagementsystem für ein Fernmeldenetz, bei dem ein Leitungsbruch über eine Kapazitätsmessung infolge des verringerten Kapazitätsbelages der Leitungen festgestellt werden kann.

Als Energie und Material sparende Lösung kommt daher in zunehmendem Maße das IT-Stromversorgungssystem in der Ausführung als 400 V-Gleichspannungs-IT-Stromversorgungssystem (DC-IT-Stromversorgungssystem) mit moderner Umrichtertechnik auch in dem Bereich der Telekommunikation zum Einsatz. Dabei wird die 400 VDC-Spannung oftmals über kilometerweite Leitungen zu den Betriebsmitteln geführt. Um Materialkosten zu sparen, wird auf eine Mitführung des Schutzleiters verzichtet. Die Schutzerdung von leitfähigen, berührbaren Teilen der Betriebsmittel erfolgt vor Ort über eine vorhandene Gebäudeerdung, ähnlich der unabhängigen Erdung der Betriebsmittel in der Netzform TT-System (frz. Terre Terre - TT).

Ein Leitungsbruch in solch einem weit ausgedehnten IT-Stromversorgungssystem birgt die Gefahr einer direkten Berührung eines aktiven Leiters des Stromversorgungssystems in sich und kann damit zu einer Personengefährdung führen. Die direkte Berührung eines oder beider aktiven Leiter würde in dem DC-IT-Stromversorgungssystem nicht sicher durch eine Fehlerstromschutzeinrichtung erkennbar sein, da der Fehlerstromkreis in einem IT-Stromversorgungssystem nicht geschlossen ist. Während bei der direkten Berührung nur eines aktiven Leiters in einem DC-IT-Stromversorgungssystem mit hohem Isolationsniveau und geringen Netzableitkapazitäten noch kein gefährlicher Körperstrom fließen sollte, so ist die direkte Berührung von zwei aktiven Leitern auch in einem DC-IT-Stromversorgungssystem mit einer Gefährdung verbunden.

Selbst wenn ein Isolationsüberwachungsgerät in einem DC-IT-Stromversorgungssystem dazu genutzt wird, um bei einem ersten Fehler, also bei Auslösen eines (Haupt-)Alarms wegen eines unterschrittenen Isolationswiderstandswertes, die Stromversorgung abzuschalten, wird das automatische Abschalten der Stromversorgung bei direktem Berühren von beiden aktiven Leitern bei den meisten Isolationsüberwachungsgeräten nicht die vorgesehenen Schutzmaßnahmen gemäß der harmonisierten Norm HD 60364-4-41:2007 "Low-voltage electrical installations - Part 4-41: Protection for safety - Protection against electric shock" zum Schutz gegen elektrischen Schlag erfüllen können.

Wird das gleichzeitige Berühren von zwei aktiven Leitern in einem IT-Stromversorgungssystem im Rahmen einer Risikobetrachtung als nicht akzeptables Restrisiko erkannt, so sind Maßnahmen zur Reduzierung dieses Restrisikos zu treffen.

Bislang angewendete Schutzmaßnahmen wie beispielsweise eine doppelte oder verstärkte Isolierung oder wie der Schutz durch Sicherheitskleinspannung (engl. Safety Extra Low Voltage, SELV) oder durch schützende Kleinspannung (engl. Protective Extra Low Voltage, PELV) stehen häufig im Widerspruch zu den Anforderungen, die hinsichtlich der Versorgungssicherheit und unter Kostengesichtspunkten an ein Stromversorgungssystem gestellt werden.

So werden auch im Telekommunikationsbereich häufig die Schutzmaßnahmen durch SELV oder PELV angewendet, diese sind allerdings aufgrund ihrer niedrigen Spannungen nicht mehr anwendbar, falls aus Gründen der Energie- und Materialeffizienz 400 VDC Stromversorgungssysteme zum Einsatz kommen sollen.

Der vorliegenden Erfindung liegt somit die Aufgabe zu Grunde, eine technische Lösung anzugeben, die in einem ungeerdeten Gleichspannungs-Stromversorgungssystem die Gefährdung bei versehentlichem Berühren von zwei aktiven Leitern minimiert.

Diese Aufgabe wird in einer ersten Alternative durch ein Verfahren gelöst, das erfindungsgemäß die folgenden Verfahrensschritte umfasst: Anschließen einer ohmschen Minimallast zum Erzeugen eines minimalen Laststroms auf den aktiven Leitern, Bestimmen eines aktuellen Laststroms, Prüfen, ob der aktuelle Laststrom den Wert des minimalen Laststroms unterschreitet, und Signalisieren einer Unterschreitung.

Um während des Betriebs des DC-IT-Stromversorgungssystems einen minimalen Laststromfluss auf den aktiven Leitern zu erzeugen, wird verbrauchernah, d.h. möglichst in unmittelbarer Nähe des tatsächlichen Betriebsmittel-/Verbraucheranschlusses, eine Minimallast als Grundlast in das Stromversorgungssystem eingebracht.

Der augenblickliche Stromfluss in dem Stromversorgungssystem wird während des Betriebs im Sinne einer Überwachung des aktuellen Laststroms fortlaufend bestimmt und besitzt aufgrund der angeschlossenen Minimallast mindestens den Wert des minimalen Laststroms. Tritt nun, beispielsweise durch einen Leitungsbruch, eine Unterbrechung eines aktiven Leiters auf, so kann auch der minimale Laststrom nicht mehr fließen. Der gemessene aktuelle Laststrom geht auf einen Betrag nahe Null zurück und unterschreitet damit den Wert des minimalen Laststroms.

Dieses Unterschreiten liefert damit einen eindeutigen Hinweis auf eine Unterbrechung eines aktiven Leiters und wird signalisiert. Die Signalisierung kann in Form einer Warnmeldung erfolgen, worauf entsprechende weitere Maßnahmen ergriffen werden können, um die elektrischen Sicherheit der Anlage zu gewährleisten. Die Signalisierung kann auch die Erzeugung eines Abschaltsignals umfassen, das in Verbindung mit einer Abschalteinrichtung oder einem Unterstromrelais (siehe unten) eine automatische Abschaltung des Stromversorgungssystems auslöst.

Als weiterer Vorteil werden während des Normalbetriebs des Stromversorgungsystem fehlerhafte Abschaltungen durch betriebsmäßig auftretenden Lastschwankungen vermieden, da aufgrund des verbrauchernahen Anschlusses der Minimallast stets ein minimaler Laststrom fließt.

In weiterer Ausgestaltung des Verfahrens erfolgt bei Unterschreiten des minimalen Laststrom-Wertes eine Abschaltung des Stromversorgungssystems mittels eines Unterstromrelais.

Im Hinblick auf eine weitere Risikominimierung ist die Signalisierung der Unterschreitung des minimalen Laststrom-Wertes mit einer automatischen Abschaltung des Stromversorgungssystems verbunden. Mit einem Unterstromrelais wird eine Unterschreitung des minimalen Laststrom-wertes festgestellt - wobei dieser Schritt implizit auch ein Bestimmen des aktuellen Laststroms umfasst. Bei Erkennen dieser Unterschreitung löst das Unterstromrelais aus und es erfolgt eine Abschaltung des Stromversorgungssystems. In Kombination mit einem an das Unterstromrelais angeschlossenen allstromsensitiven Messstromwandler kann das Verfahren gemäß der ersten Alternativlösung in einfacherer Weise unmittelbar umgesetzt werden.

Die Aufgabe wird in einer zweiten Alternative durch ein Verfahren gelöst, das erfindungsgemäß die folgenden Verfahrensschritte umfasst: Anschließen eines hochohmigen Widerstands jeweils zwischen einem aktiven Leiter und Erde, Bestimmen eines aktuellen Gesamtisolationswiderstands des Stromversorgungssystems mit einem Isolationsüberwachungsgerät, Prüfen, ob der aktuelle Gesamtisolationswiderstand einen Grenzwert überschreitet, und Signalisieren einer Überschreitung.

Bei dieser Alternative wird jeweils ein hochohmiger Widerstand verbrauchernah zwischen einen aktiven Leiter und Erde geschaltet. Die Widerstände sind so hochohmig ausgelegt, dass sie die Eigenschaft des Versorgungsnetzes als ungeerdetes Stromversorgungssystem nicht beeinträchtigen, wohl aber bei einer Betrachtung des Gesamtisolationswiderstands nicht vernachlässigbar sind.

Findet eine Unterbrechung eines aktiven Leiters statt, so wird auch der Strompfad über den eingefügten hochohmigen Widerstand abgetrennt und damit der Gesamtisolationswiderstand erhöht.

Einspeiseseitig wird mit einem Isolationsüberwachungsgerät der aktuelle Gesamtisolationswiderstand des Stromversorgungssystems bestimmt und daraufhin überprüft, ob dieser aktuelle Gesamtisolationswiderstand einen Grenzwert überschreitet. Eine Überschreitung des Grenzwertes und damit eine Information über den Betriebszustand des Stromversorgungssystems werden signalisiert.

Das Verfahren gemäß der zweiten Alternativlösung ist in allen DC-IT-Stromversorgungssystemen, in denen ein normgemäß vorgeschriebenes und normgerecht ausgeführtes Isolationsüberwachungsgerät installiert ist, unmittelbar anwendbar.

In weiterer Ausgestaltung wird der Gesamtisolationswiderstands-Grenzwert in Abhängigkeit eines Stromversorgungssystem-spezifischen Isolationswiderstandswertes und in Abhängigkeit der angeschlossenen hochohmigen Widerstände festgelegt.

Der Gesamtisolationswiderstands-Grenzwert, bei dessen Überschreitung eine mögliche Gefährdung signalisiert wird, ergibt sich aus einem für das betreffende Stromversorgungsystem individuellen Isolationsniveau, das durch einen spezifischen Isolationswiderstandswert wiedergegeben wird, und den verbrauchernah angeschlossenen hochohmigen Widerständen.

Mit Vorteil erfolgt bei Überschreiten des Gesamtisolationswiderstands-Grenzwertes eine Abschaltung des Stromversorgungssystems.

Die Signalisierung umfasst unmittelbar auch eine automatische Abschaltung der Stromversorgung, um jegliche Gefährdung durch Berühren aktiver Anlagenteile auszuschließen.

Die Aufgabe wird in einer dritten Alternative durch ein Verfahren gelöst, das erfindungsgemäß die folgenden Verfahrensschritte umfasst: Anschließen eines hochohmigen Widerstands jeweils zwischen einem aktiven Leiter und Erde, Bestimmen einer aktuellen Verlagerungsspannung zwischen einem zusammengeschalteten Punkt aller aktiven Leiter und Erde, Prüfen, ob die aktuelle Verlagerungsspannung einen Grenzwert überschreitet, und Signalisieren einer Überschreitung.

Wie bei dem zweiten Verfahren wird jeweils ein hochohmiger Widerstand verbrauchernah zwischen einen aktiven Leiter und Erde geschaltet. Auf der Einspeiseseite wird zwischen einem zusammengeschalteten Punkt aller aktiven Leiter - vergleichbar mit einem Sternpunkt - und Erde fortlaufend im Sinne einer Überwachung eine aktuelle Verlagerungsspannung bestimmt. Im Fall einer Unterbrechung mindestens eines aktiven Leiters wird ein erhöhter Wert der Verlagerungsspannung gemessen, sodass durch einen Vergleich der aktuellen Verlagerungsspannung mit einem Verlagerungsspannungs-Grenzwert eine Unterbrechung eines aktiven Leiters festgestellt und bei einer Überschreitung des Verlagerungsspannungs-Grenzwertes ein Gefährdungszustand signalisiert werden kann.

In weiterer Ausgestaltung wird der Verlagerungsspannungs-Grenzwert in Abhängigkeit eines Stromversorgungssystem-spezifischen Isolationswiderstandswertes und in Abhängigkeit der angeschlossenen hochohmigen Widerstands/Widerstände sowie in Abhängigkeit einer Nennspannung des Stromversorgungssystems festgelegt

Zur Festlegung des Verlagerungsspannungs-Grenzwertes, bei dessen Überschreitung eine mögliche Gefährdung signalisiert wird, werden die folgenden Größen berücksichtigt: das durch einen spezifischen Isolationswiderstandswert wiedergegebene individuelle Isolationsniveau des IT-Stromversorgungsystems, die angeschlossenen hochohmigen Widerstände sowie die Nennspannung des IT-Stromversorgungssystems.

In vorteilhafter Weise erfolgen das Bestimmen der aktuellen Verlagerungsspannung und ein Abschalten des Stromversorgungssystems bei Überschreiten des Verlagerungsspannungs-Grenzwertes durch ein Spannungsrelais.

Zur Überwachung der aktuellen Verlagerungsspannung wird in dieser Ausgestaltung ein Spannungsrelais eingesetzt, das die Stromversorgung bei einer Überschreitung des Verlagerungsspannungs-Grenzwertes trennt.

Alternativ erfolgen das Bestimmen der aktuellen Verlagerungsspannung mittels einer in einem Isolationsüberwachungsgerät integrierten Spannungsmessfunktion und ein Abschalten des Stromversorgungssystems bei Überschreiten des Verlagerungsspannungs-Grenzwertes mittels einer Abschalteinrichtung.

Mit Vorteil kann das Bestimmen der aktuellen Verlagerungsspannung in einem erweiterten Isolationsüberwachungsgerät mit integrierter Spannungsmessfunktion durchgeführt werden. Eine Abschaltung des Stromversorgungssystems erfolgt dann in Verbindung mit einer Abschalteinrichtung.

Die Aufgabe wird in einer vierten Alternative durch ein Verfahren gelöst, das erfindungsgemäß die folgenden Verfahrensschritte umfasst: Anschließen einer Kapazität jeweils zwischen einem aktiven Leiter und Erde, Bestimmen einer aktuellen Gesamtkapazität des Stromversorgungssystems, Prüfen, ob die aktuelle Gesamtkapazität einen Grenzwert unterschreitet, und Signalisieren einer Unterschreitung.

Zwischen einem aktiven Leiter und Erde wird jeweils eine Kapazität verbrauchernah angeschlossen. Die eingebrachten Kapazitäten weisen jeweils einen so hohen Kapazitätswert auf, dass deren Vorhandensein zwar einen messbaren Beitrag zu der aktuellen Gesamtkapazität ergibt, aber die durch die vorhandenen Ableitkapazitäten bestimmten elektrischen Eigenschaften des Netzes nur unwesentlich beeinflusst werden.

Im Fall der Unterbrechung mindestens eines aktiven Leiters wird die zusätzlich eingebrachte Kapazität abgetrennt und der Wert der Gesamtkapazität des Stromversorgungssystems verringert sich.

Während des Betriebs der Anlage findet einspeiseseitig eine fortlaufende Bestimmung der aktuellen Gesamtkapazität des Stromversorgungsystems statt. Die ermittelte aktuelle Gesamtkapazität wird daraufhin überprüft, ob sie einen Gesamtkapazitäts-Grenzwert unterschreitet und eine Unterschreitung gegebenenfalls signalisiert.

In weiterer Ausgestaltung wird der Gesamtkapazitäts-Grenzwert in Abhängigkeit Stromversorgungssystem-spezifischer Ableitkapazitäten und in Abhängigkeit der angeschlossenen Kapazitäten festgelegt.

Der Gesamtkapazitäts-Grenzwert ergibt sich unter Berücksichtigung der das IT-Stromversorgungssystem charakterisierenden Ableitkapazitäten sowie der zusätzlichen verbrauchernah angeschlossenen Kapazitäten.

Weiter erfolgt das Bestimmen der aktuellen Gesamtkapazität mittels eines Kapazitätsmessgeräts und/oder mittels eines Isolationsüberwachungsgeräts mit integrierter Kapazitätsmessfunktion.

Bei Unterschreiten des Gesamtkapazitäts-Grenzwertes erfolgt eine Abschaltung des Stromversorgungssystems.

Die Aufgabe wird in einer fünften Alternative durch ein Verfahren gelöst, das erfindungsgemäß die folgenden Verfahrensschritte umfasst: Anschließen einer Kapazität mit hinreichend hohem Kapazitätswert jeweils zwischen einem aktiven Leiter und Erde, Bestimmen einer aktuellen Gesamtimpedanz des Stromversorgungssystems, Prüfen, ob die aktuelle Gesamtimpedanz einen Grenzwert überschreitet, und Signalisieren einer Überschreitung.

Wie in der vierten Alternative wird zwischen einem aktiven Leiter und Erde jeweils eine Kapazität mit hinreichend hohem Kapazitätswert verbrauchernah geschaltet.

Im Unterschied zur der vierten Alternative aber wird eine Bestimmung einer aktuellen Gesamtimpedanz durchgeführt und die aktuelle Gesamtimpedanz auf eine Überschreitung eines Gesamtimpedanz-Grenzwertes überprüft.

Der Gesamtimpedanz-Grenzwert wird wie in der vierten Alternative in Abhängigkeit eines Stromversorgungssystem-spezifischem Isolationswiderstandswertes und in Abhängigkeit Stromversorgungssystem-spezifischer Ableitkapazitäten sowie in Abhängigkeit der angeschlossenen Kapazitäten festgelegt.

Vorteilhafterweise erfolgt das Bestimmen der aktuellen Gesamtimpedanz mittels eines Impedanzmessgeräts und/oder mittels eines Isolationsüberwachungsgeräts mit integrierter Impedanzmessfunktion.

Insbesondere der Einsatz eines Isolationsüberwachungsgeräts mit integrierter Impedanzmessfunktion vereinfacht die Anwendung des Verfahrens gemäß der fünften Alternativlösung.

Bei Überschreiten des Gesamtimpedanz-Grenzwertes erfolgt eine Abschaltung des Stromversorgungssystems.

Weiterhin wird die Aufgabe durch ein Verfahren gelöst, das zur redundanten Erkennung der Unterbrechung des aktiven Leiters mindestens zwei der Verfahren nach den Ansprüchen 1, 3, 6, 10 und 14 ausführt.

Um die Sicherheit der Erkennung der Leiterunterbrechung zu erhöhen, werden beispielweise ein auf der Bestimmung des Gesamtisolationswiderstands beruhendes Verfahren gemäß der zweiten Alternative (Anspruch 3) und ein auf der Bestimmung der Verlagerungsspannung beruhendes Verfahren gemäß der dritten Alternative (Anspruch 6) gleichzeitig implementiert und ausgeführt.

Weitere vorteilhafte Ausgestaltungsmerkmale ergeben sich aus der nachfolgenden Beschreibung und den Zeichnungen, die bevorzugte Anwendungen der Erfindung an Hand von Beispielen erläutern. Es zeigen:
- **Fig. 1:**: ein ungeerdetes Gleichspannungs-Stromversorgungssystem mit Bestimmung eines aktuellen Laststroms,
- **Fig. 2:**: ein ungeerdetes Gleichspannungs-Stromversorgungssystem mit Bestimmung eines aktuellen Gesamtisolationswiderstands,
- **Fig. 3:**: ein ungeerdetes Gleichspannungs-Stromversorgungssystem mit Bestimmung einer aktuellen Verlagerungsspannung,
- **Fig. 4:**: ein ungeerdetes Gleichspannungs-Stromversorgungssystem mit Bestimmung einer aktuellen Gesamtkapazität und
- **Fig. 5:**: ein ungeerdetes Gleichspannungs-Stromversorgungssystem mit Bestimmung einer aktuellen Gesamtimpedanz.

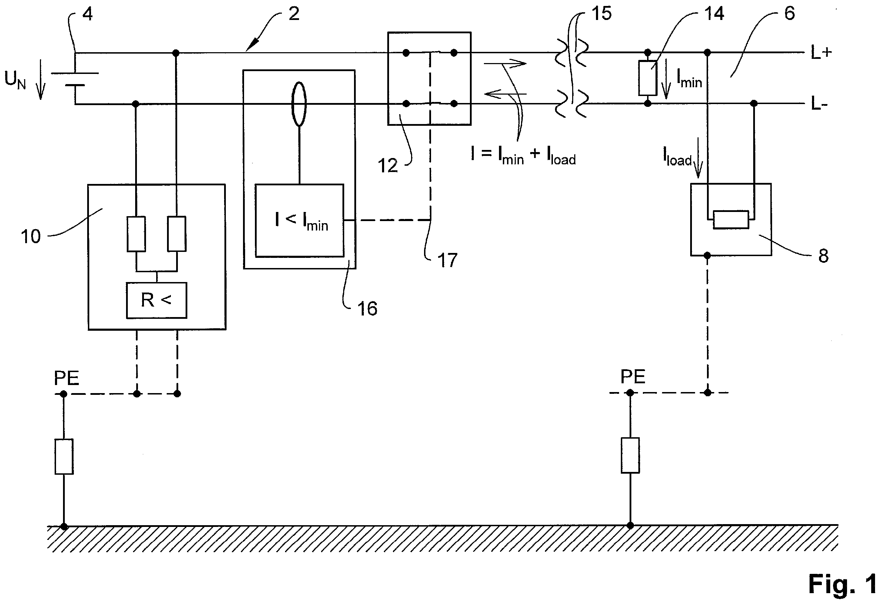

Für alle beanspruchten Alternativlösungen ist jeweils in dem in **Fig. 1** bis **Fig. 5** dargestellten Ausführungsbeispiel ein ungeerdetes Gleichspannungs-Stromversorgungssystem 2 (DC-IT-Stromversorgungssystem) zugrunde gelegt, das zwei aktive Leiter L+, L- aufweist, die an einer Einspeisestelle 4 mit einer Nennspannung U_{N} beaufschlagt werden.

An einer Verbraucheranschlussstelle 6 ist ein Verbraucher 8 (Betriebsmittel) an die aktiven Leiter L+, L- angeschlossen. Das DC-IT-Stromversorgungssystem 2 wird vorschriftsmäßig von einem Isolationsüberwachungsgerät 10 überwacht, das zwischen die aktiven Leiter L+, L-und Erde PE geschaltet ist.

Ein Abschalten des DC-IT-Stromversorgungssystems 2 wird durch eine Abschalteinrichtung 12 ausgeführt. Die Abschalteinrichtung 12 ist in den **Fig. 1** bis **Fig. 5** als funktionale Einheit zu verstehen, die als eigenständiges Gerät ausgeführt sein kann, aber auch baulich in andere an das DC-IT-Stromversorgungssystem 2 angeschlossene Mess- und Überwachungsgeräte integriert sein kann.

In **Fig. 1** ist als erste Alternativlösung der Anschluss einer ohmschen Minimallast 14 zwischen den aktiven Leitern L+, L- in Verbindung mit einer Bestimmung eines aktuellen Laststroms I veranschaulicht. Die Minimallast 14 ist möglichst verbrauchernah anzubringen, zumindest aber so weit von der Abschalteinrichtung 12 entfernt, dass ein gewünschter zu überwachender Leitungsabschnitt, auf dem eine mögliche Leiterunterbrechung 15 auftreten kann, zwischen der Abschalteinrichtung 12 und der Verbraucheranschlussstelle 6 der Minimallast 14 liegt.

Die Minimallast 14 erzeugt einen minimalen Laststrom Iₘᵢₙ, der auch bei dem ausgeschalteten Verbraucher 8 über die aktiven Leiter L+, L- von und zu der Einspeisestelle 4 fließt und somit zur Erkennung einer funktionstüchtigen Leitung dient.

Zusammen mit einem über den Verbraucher 8 fließenden Laststrom I_{load} bildet der minimale Laststrom Iₘᵢₙ einen aktuellen Laststrom I. Dieser aktuelle Laststrom I wird von einer Strommesseinrichtung 16 auf einem der aktiven Leiter L+, L- erfasst und daraufhin geprüft, ob er den Wert des minimalen Laststroms Iₘᵢₙ unterschreitet. Im Fall einer Leiterunterbrechung 15 auf mindestens einem aktiven Leiter L+, L- geht der aktuelle Laststrom I auf einen Betrag nahe Null zurück und unterschreitet damit den Wert des minimalen Laststroms Iₘᵢₙ. Dies wird von einer Strommesseinrichtung 16 erkannt und signalisiert, wobei die Signalisierung die Erzeugung eines Abschaltsignals 17 zum Auslösen der Abschalteinrichtung 12 umfasst.

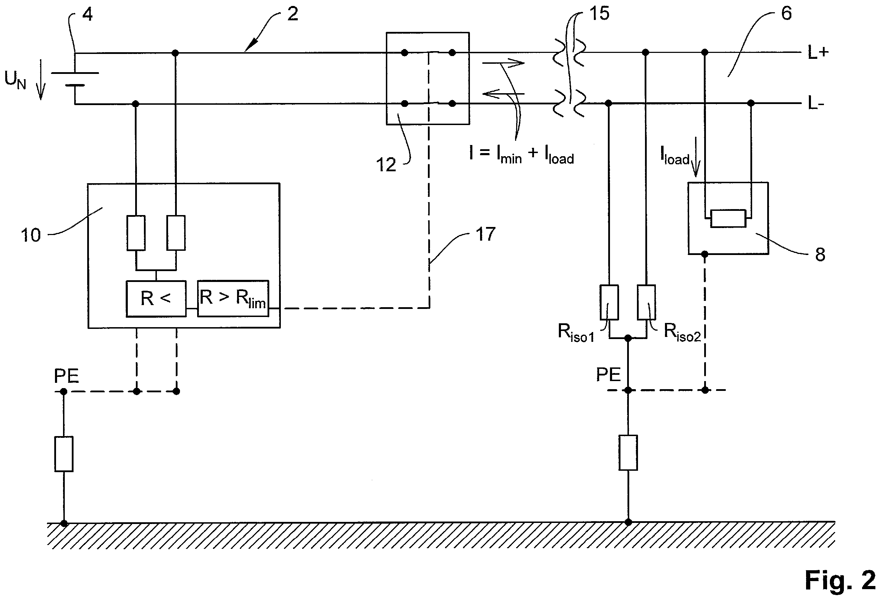

**Fig. 2** zeigt als zweite Alternativlösung den Anschluss eines hochohmigen Widerstands Rᵢₛₒ₁, Rᵢₛₒ₂ jeweils zwischen einem der aktiven Leiter L+, L- und Erde PE in Verbindung mit einer Bestimmung eines aktuellen Gesamtisolationswiderstands Rᵢₛₒ des Stromversorgungssystems 2 mit einem Isolationsüberwachungsgerät 10.

Tritt eine Leiterunterbrechung 15 - von der Einspeisestelle 4 aus betrachtet - vor der Anschlussstelle der eingefügten hochohmigen Widerstände Rᵢₛₒ₁, Rᵢₛₒ₂ auf, so erhöht sich infolge der Trennung mindestens eines der über die eingefügten Widerstände Rᵢₛₒ₁, Rᵢₛₒ₂ führenden Strompfade der aktuelle Gesamtisolationswiderstand R des Stromversorgungssystems 2. Das Überschreiten eines voreingestellten Gesamtisolationswiderstands-Grenzwertes Rₗᵢₘ durch den aktuellen Gesamtisolationswiderstand R wird von dem Isolationsüberwachungsgerät 10 erkannt und in Form des Abschaltsignals 17 an die Abschalteinrichtung 12 signalisiert.

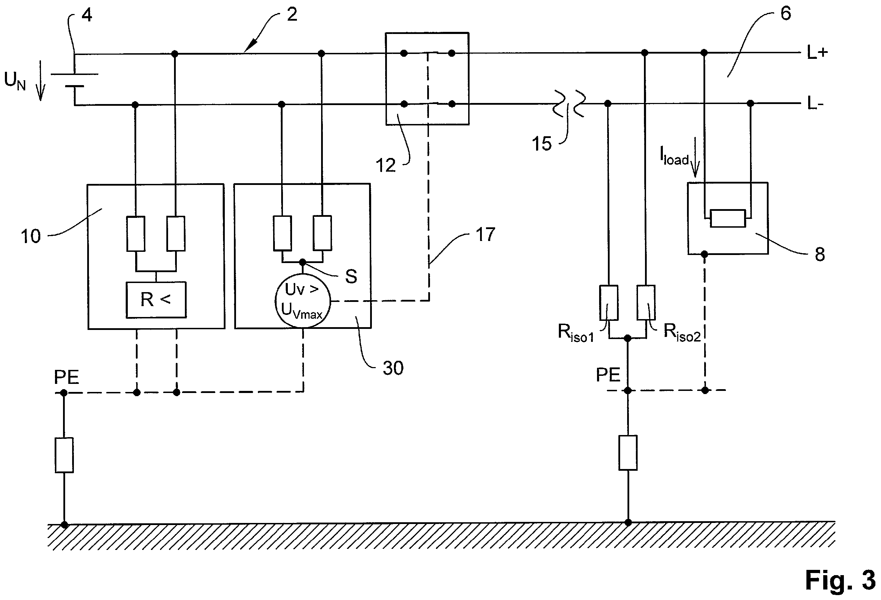

In **Fig. 3** ist als dritte Alternativlösung der Anschluss eines hochohmigen Widerstands Rᵢₛₒ₁, Rᵢₛₒ₂ jeweils zwischen einem der aktiven Leiter L+, L-und Erde PE in Verbindung mit der Bestimmung einer aktuellen Verlagerungsspannung U_{V} zwischen einem zusammengeschalteten Punkt S aller aktiven Leiter L+, L- und Erde PE dargestellt.

Wie in der zweiten Alternativlösung sind verbrauchernah die hochohmigen Widerstände Rᵢₛₒ₁, Rᵢₛₒ₂ jeweils zwischen einem aktiven Leiter L+, L-und Erde PE angeschlossen.

Auf der Einspeiseseite wird zwischen einem zusammengeschalteten Punkt S aller aktiven Leiter L+, L- und Erde PE die aktuelle Verlagerungsspannung U_{V} mittels eines Gerätes mit Spannungsmessfunktion 30 bestimmt. Im Fall einer Unterbrechung 15 mindestens eines aktiven Leiters L+, L- ergibt sich ein erhöhter Wert der Verlagerungsspannung U_{V}, sodass bei einer Überschreitung des Verlagerungsspannungs-Grenzwertes U_{Vmax} ein Gefährdungszustand signalisiert und in Form eines Abschaltsignals 17 an die Abschalteinrichtung 12 weitergegeben werden kann.

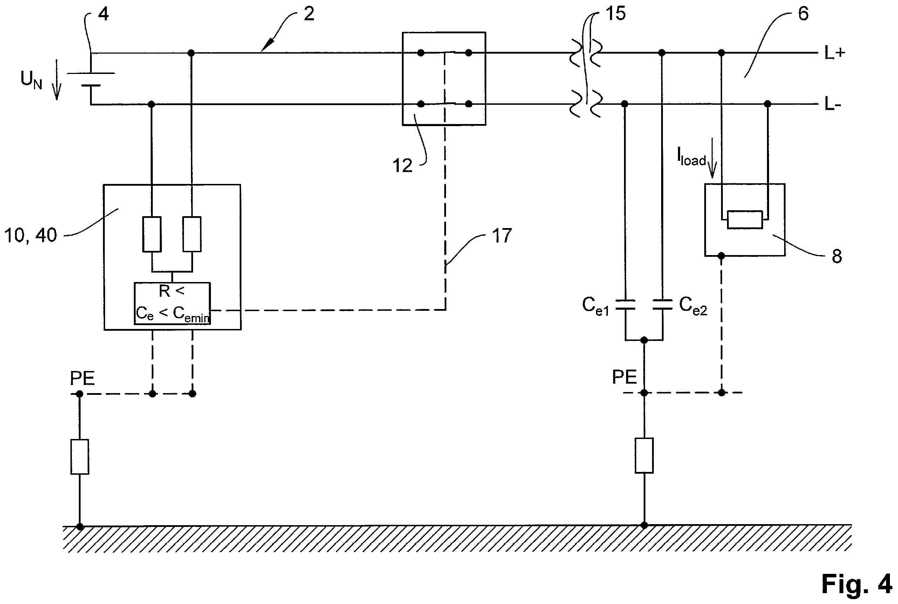

**Fig. 4** zeigt als vierte Alternativlösung den Anschluss einer Kapazität Cₑ₁, Cₑ₂ jeweils zwischen einem der aktiven Leiter L+, L- und Erde PE in Verbindung mit der Bestimmung einer aktuellen Gesamtkapazität Cₑ des Stromversorgungssystems 2.

Das verbrauchernahe Einfügen der Kapazitäten Cₑ₁, Cₑ₂ bewirkt im Normalbetrieb eine Erhöhung der aktuellen Gesamtkapazität Cₑ des Stromversorgungssystems 2. Eine Trennung der eingefügten Kapazitäten Cₑ₁, Cₑ₂ infolge einer Leiterunterbrechung 15 ist demzufolge als Abnahme der aktuellen Gesamtkapazität Cₑ durch ein Gerät mit einer Kapazitätsmessfunktion 40 feststellbar. In dem dargestellten Ausführungsbeispiel ist die Kapazitätsmessfunktion 40 in das Isolationsüberwachungsgerät 10 integriert.

Unterschreitet die bestimmte aktuelle Gesamtkapazität Cₑ einen Gesamtkapazitäts-Grenzwert Cₑₘᵢₙ, wird dies erkannt und mittels Abschaltsignal 17 signalisiert.

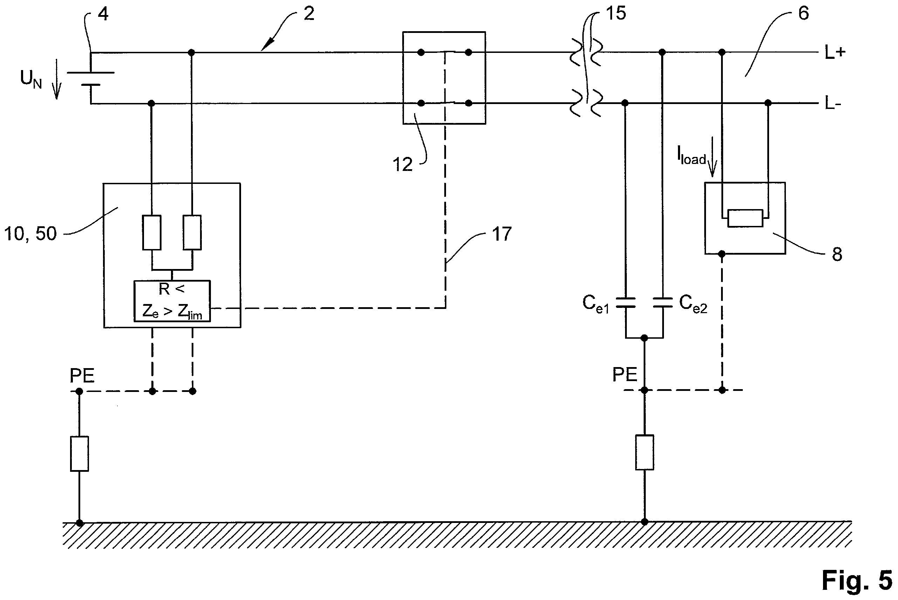

Die in **Fig. 5** gezeigte fünfte Alternativlösung unterscheidet sich von der vierten Alternative lediglich dadurch, dass anstelle der Auswertung der aktuellen Gesamtkapazität Cₑ eine Auswertung einer aktuellen Gesamtimpedanz Zₑ durchgeführt wird. Der Vergleich der bestimmten aktuellen Gesamtimpedanz Zₑ mit einem Gesamtimpedanz-Grenzwert Zₑₘᵢₙ kann vorteilhafterweise in einem Isolationsüberwachungsgerät 10 mit integrierter Impedanzmessfunktion 50 durchgeführt werden. Die Gesamtimpedanz gegen Erde kann beispielsweise bei einer Netzfrequenz von 50 Hz überwacht werden. Wird infolge einer Leiterunterbrechung 15 eine Impedanzerhöhung festgestellt, wobei die aktuelle Gesamtimpedanz Zₑ den Gesamtimpedanz-Grenzwert Zₗᵢₘ überschreitet, sendet das Isolationsüberwachungsgerät 10 ein Abschaltsignal 10 an die Abschalteinrichtung 12.

## Patentansprüche

1. Verfahren zum Erkennen einer Unterbrechung eines aktiven Leiters (L+, L-) in einem ungeerdeten Gleichspannungs-Stromversorgungssystem (2), umfassend die Verfahrensschritte:
- möglichst verbrauchernahes Anschließen einer ohmschen Minimallast (14) zum Erzeugen eines minimalen Laststroms (Iₘᵢₙ) auf den aktiven Leitern (L+, L-),
- Bestimmen eines aktuellen Laststroms (I),
- Prüfen, ob der aktuelle Laststrom (I) den Wert des minimalen Laststroms (Iₘᵢₙ) unterschreitet, und Signalisieren einer Unterschreitung.

2. Verfahren nach Anspruch 1,
**dadurch gekennzeichnet,**
**dass** bei Unterschreiten des minimalen Laststrom-Wertes (Iₘᵢₙ) eine Abschaltung des Stromversorgungssystems (2) mittels eines Unterstromrelais erfolgt.

3. Verfahren zum Erkennen einer Unterbrechung eines aktiven Leiters (L+, L-) in einem ungeerdeten Gleichspannungs-Stromversorgungssystem (2), umfassend die Verfahrensschritte:
- möglichst verbrauchernahes Anschließen eines hochohmigen Widerstands (Rᵢₛₒ₁, Rᵢₛₒ₂) jeweils zwischen einem aktiven Leiter (L+, L-) und Erde,
- Bestimmen eines aktuellen Gesamtisolationswiderstands (R) des Stromversorgungssystems (2) mit einem Isolationsüberwachungsgerät (10),
- Prüfen, ob der aktuelle Gesamtisolationswiderstand (R) einen Grenzwert (Rₗᵢₘ) überschreitet, und Signalisieren einer Überschreitung.

4. Verfahren nach Anspruch 3,
**dadurch gekennzeichnet,**
**dass** der Gesamtisolationswiderstands-Grenzwert (Rₗᵢₘ) in Abhängigkeit eines Stromversorgungssystem-spezifischen Isolationswiderstandswertes und in Abhängigkeit der angeschlossenen hochohmigen Widerstände (Rᵢₛₒ₁, Rᵢₛₒ₂) festgelegt wird.

5. Verfahren nach Anspruch 3 oder 4,
**dadurch gekennzeichnet,**
**dass** bei Überschreiten des Gesamtisolationswiderstands-Grenzwertes (Rₗᵢₘ) eine Abschaltung des Stromversorgungssystems (2) erfolgt.

6. Verfahren zum Erkennen einer Unterbrechung eines aktiven Leiters (L+, L-) in einem ungeerdeten Gleichspannungs-Stromversorgungssystem (2), umfassend die Verfahrensschritte:
- möglichst verbrauchernahes Anschließen eines hochohmigen Widerstands jeweils zwischen einem aktiven Leiter (L+, L-) und Erde,
- Bestimmen einer aktuellen Verlagerungsspannung (U_{V}) zwischen einem zusammengeschalteten Punkt aller aktiven Leiter (L+, L-) und Erde,
- Prüfen, ob die aktuelle Verlagerungsspannung (U_{V}) einen Grenzwert (U_{Vmax}) überschreitet, und Signalisieren einer Überschreitung.

7. Verfahren nach Anspruch 6,
**dadurch gekennzeichnet,**
**dass** der Verlagerungsspannungs-Grenzwert (U_{Vmax}) in Abhängigkeit eines Stromversorgungssystem-spezifischen Isolationswiderstandswertes und in Abhängigkeit der angeschlossenen hochohmigen Widerstände sowie in Abhängigkeit einer Nennspannung (U_{N}) des Stromversorgungssystems (2) festgelegt wird.

8. Verfahren nach Anspruch 6 oder 7,
**dadurch gekennzeichnet,**
**dass** das Bestimmen der aktuellen Verlagerungsspannung (U_{V}) und bei Überschreiten des Verlagerungsspannungs-Grenzwertes (U_{Vmax}) ein Abschalten des Stromversorgungssystems (2) durch ein Spannungsrelais erfolgen.

9. Verfahren nach Anspruch 6 oder 7,
**dadurch gekennzeichnet,**
**dass** das Bestimmen der aktuellen Verlagerungsspannung (U_{V}) mittels einer in einem Isolationsüberwachungsgerät (10) integrierten Spannungsmessfunktion (30) und bei Überschreiten des Verlagerungsspannungs-Grenzwertes (U_{Vmax}) ein Abschalten des Stromversorgungssystems (2) mittels einer Abschalteinrichtung erfolgen.

10. Verfahren zum Erkennen einer Unterbrechung eines aktiven Leiters (L+, L-) in einem ungeerdeten Gleichspannungs-Stromversorgungssystem (2), umfassend die Verfahrensschritte:
- möglichst verbrauchernahes Anschließen einer Kapazität (Cₑ₁, Cₑ₂) jeweils zwischen einem aktiven Leiter (L+, L-) und Erde,
- Bestimmen einer aktuellen Gesamtkapazität (Cₑ) des Stromversorgungssystems (2),
- Prüfen, ob die aktuelle Gesamtkapazität (Cₑ) einen Grenzwert (Cₑ₋ₘᵢₙ) unterschreitet, und Signalisieren einer Unterschreitung.

11. Verfahren nach Anspruch 10,
**dadurch gekennzeichnet,**
**dass** der Gesamtkapazitäts-Grenzwert (Cₑₘᵢₙ) in Abhängigkeit Stromversorgungssystem-spezifischer Ableitkapazitäten und in Abhängigkeit der angeschlossenen Kapazitäten (Cₑ₁, Cₑ₂) festgelegt wird.

12. Verfahren nach Anspruch 10 oder 11,
**dadurch gekennzeichnet,**
**dass** das Bestimmen der aktuellen Gesamtkapazität (Cₑ) mittels eines Kapazitätsmessgeräts und/oder mittels eines Isolationsüberwachungsgeräts mit integrierter Kapazitätsmessfunktion erfolgt.

13. Verfahren nach einem der Ansprüche 10 bis 12,
**dadurch gekennzeichnet,**
**dass** bei Unterschreiten des Gesamtkapazitäts-Grenzwertes (Cₑₘᵢₙ) eine Abschaltung des Stromversorgungssystems (2) erfolgt.

14. Verfahren zum Erkennen einer Unterbrechung eines aktiven Leiters (L+, L-) in einem ungeerdeten Gleichspannungs-Stromversorgungssystem (2), umfassend die Verfahrensschritte:
- möglichst verbrauchernahes Anschließen einer Kapazität (Cₑ₁, Cₑ₂) jeweils zwischen einem aktiven Leiter (L+, L-) und Erde,
- Bestimmen einer aktuellen Gesamtimpedanz (Zₑ) des Stromversorgungssystems (2),
- Prüfen, ob die aktuelle Gesamtimpedanz (Zₑ) einen Grenzwert (Zₗᵢₘ) überschreitet, und Signalisieren einer Überschreitung.

15. Verfahren nach Anspruch 14,
**dadurch gekennzeichnet,**
**dass** der Gesamtimpedanz-Grenzwert (Zₗᵢₘ) in Abhängigkeit eines Stromversorgungssystem-spezifischem Isolationswiderstandswertes und in Abhängigkeit Stromversorgungssystem-spezifischer Ableitkapazitäten sowie in Abhängigkeit der angeschlossenen Kapazitäten (Cₑ₁, Cₑ₂) festgelegt wird.

16. Verfahren nach Anspruch 14 oder 15,
**dadurch gekennzeichnet,**
**dass** das Bestimmen der aktuellen Gesamtimpedanz (Zₑ) mittels eines Impedanzmessgeräts und/oder mittels eines Isolationsüberwachungsgeräts (10) mit integrierter Impedanzmessfunktion (50) erfolgt.

17. Verfahren nach einem der Ansprüche 14 bis 16,
**dadurch gekennzeichnet,**
**dass** bei Überschreiten des Gesamtimpedanz-Grenzwertes (Zₗᵢₘ) eine Abschaltung des Stromversorgungssystems (2) erfolgt.

18. Verfahren zum Erkennen einer Unterbrechung eines aktiven Leiters (L+, L-) in einem ungeerdeten Gleichspannungs-Stromversorgungssystem (2),
**dadurch gekennzeichnet,**
**dass** zur redundanten Erkennung der Unterbrechung des aktiven Leiters (L+, L-) mindestens zwei der Verfahren nach den Ansprüchen 1, 3, 6, 10 und 14 ausgeführt werden.

## Claims

1. A method for detecting an interruption of an active conductor (L+, L-) in an ungrounded direct-voltage power supply system (2), the method comprising the steps of:
- connecting an ohmic minimal load (14) as close as possible to the consumer to generate a minimal load current (Iₘᵢₙ) on the active conductors (L+, L-),
- determining a current load current (I),
- checking whether the current load current (I) falls short of the value of the minimal load current (Iₘᵢₙ), and signaling a shortfall.

2. The method according to claim 1,
**characterized in that**
if the load current falls short of the minimal load-current value (Iₘᵢₙ), the power supply system (2) is shut off by means of an undercurrent relay.

3. A method for detecting an interruption of an active conductor (L+, L-) in an ungrounded direct-voltage power supply system (2), the method comprising the steps of:
- connecting a high-resistance resistor (Rᵢₛₒ₁, Rᵢₛₒ₂) as close as possible to the consumer between each active conductor (L+, L-) and ground,
- determining a current total insulation resistance (R) of the power supply system (2) by means of an insulation monitoring device (10),
- checking whether the current total insulation resistance (R) exceeds a limit value (Rₗᵢₘ), and signaling an exceedance.

4. The method according to claim 3,
**characterized in that**
the total-insulation-resistance limit value (Rₗᵢₘ) is defined as a function of an insulation resistance value specific to the power supply system and as a function of the connected high-resistance resistors (Rᵢₛₒ₁, Rᵢₛₒ₂).

5. The method according to claim 3 or 4,
**characterized in that**
if the total insulation resistance exceeds the limit value (Rₗᵢₘ), the power supply system (2) is shut off.

6. A method for detecting an interruption of an active conductor (L+, L-) in an ungrounded direct-voltage power supply system (2), the method comprising the steps of:
- connecting a high-resistance resistor as close as possible to the consumer between each active conductor (L+, L-) and ground,
- determining a current displacement voltage (Uv) between an interconnected point of all active conductors (L+, L-) and ground,
- checking whether the current displacement voltage (Uv) exceeds a limit value (Uvmax), and signaling an exceedance.

7. The method according to claim 6,
**characterized in that**
the displacement-voltage limit value (Uvmax) is defined as a function of an insulation resistance value specific to the power supply system and as a function of the connected high-resistance resistors and as a function of a nominal voltage (U_{N}) of the power supply system (2).

8. The method according to claim 6 or 7,
**characterized in that**
the current displacement voltage (Uv) is determined and the power supply system (2) is shut down in case of an exceedance of the displacement-voltage limit value (Uvmax) by means of a voltage relay.

9. The method according to claim 6 or 7,
**characterized in that**
the current displacement voltage (Uv) is determined by means of a voltage measuring function (30) integrated in an insulation monitoring device (10) and the power supply system (2) is shut off by means of a shut-off means in case of an exceedance of the displacement-voltage limit value (U_{Vmax}).

10. A method for detecting an interruption of an active conductor (L+, L-) in an ungrounded direct-voltage power supply system (2), the method comprising the steps of:
- connecting a capacitance (Cₑ₁, Cₑ₂) as close as possible to the consumer between each active conductor (L+, L-) and ground,
- determining a current total capacitance (Cₑ) of the power supply system (2),
- checking whether the current total capacitance (Cₑ) falls short of a limit value (Cₑₘᵢₙ), and signaling a shortfall.

11. The method according to claim 10,
**characterized in that**
the total-capacitance limit value (Cₑₘᵢₙ) is defined as a function of leakage capacitances specific to the power supply system and as a function of the connected capacitances (Cₑ₁, Cₑ₂).

12. The method according to claim 10 or 11,
**characterized in that**
the current total capacitance (Cₑ) is determined by means of a capacitance measuring device and/or by means of an insulation monitoring device having an integrated capacitance measuring function.

13. The method according to any one of claims 10 to 12,
**characterized in that**
if the total capacitance falls short of the limit value (Cₑₘᵢₙ), the power supply system (2) is shut off.

14. A method for detecting an interruption of an active conductor (L+, L-) in an ungrounded direct-voltage power supply system (2), the method comprising the methodsteps of:
- connecting a capacitance (Cₑ₁, Cₑ₂) as close as possible to the consumer between each active conductor (L+, L-) and ground,
- determining a current total impedance (Zₑ) of the power supply system (2),
- checking whether the current total impedance (Zₑ) exceeds a limit value (Zₗᵢₘ), and signaling an exceedance.

15. The method according to claim 14,
**characterized in that**
the total-impedance limit value (Zₗᵢₘ) is defined as a function of an insulation resistance value specific to the power supply system and as a function of leakage capacitances specific to the power supply system and as a function of the connected capacitances (Cₑ₁, Cₑ₂).

16. The method according to claim 14 or 15,
**characterized in that**
the current total impedance (Zₑ) is determined by means of an impedance measuring device and/or by means of an insulation monitoring device (10) having an integrated impedance measuring function (50).

17. The method according to any one of claims 14 to 16,
**characterized in that**
if the total impedance exceeds the limit value (Zₗᵢₘ), the power supply system (2) is shut off.

18. A method for detecting an interruption of an active conductor (L+, L-) in an ungrounded direct-voltage power supply system (2),
**characterized in that**
at least two of the methods according to claims 1, 3, 6, 10 and 14 are executed for redundant detection of the interruption of the active conductor (L+, L-).

## Revendications

1. Procédé pour la détection d'une interruption d'un conducteur actif (L+, L-) dans un système (2) d'alimentation électrique en tension continue non mis à la terre, le procédé comprenant les étapes suivantes :
- relier une charge minimale (14) ohmique aussi proche que possible au consommateur afin de générer un courant de charge minimal (Iₘᵢₙ) sur les conducteurs actifs (L+, L-),
- déterminer un courant de charge (I) actuel,
- vérifier si le courant de charge (I) actuel reste inférieur à la valeur du courant de charge minimal (Iₘᵢₙ), et signaler une infériorité.

2. Procédé selon la revendication 1,
**caractérisé en ce que**
si le courant de charge minimal reste inférieur à la valeur (Iₘᵢₙ) du courant de charge minimal, le système (2) d'alimentation électrique est déclenché au moyen d'un relais à minimum de courant.

3. Procédé pour la détection d'une interruption d'un conducteur actif (L+, L-) dans un système (2) d'alimentation électrique en tension continue non mis à la terre, le procédé comprenant les étapes suivantes :
- relier une résistance (Rᵢₛₒ₁, Rᵢₛₒ₂) à haute impédance aussi proche que possible au consommateur entre chaque conducteur actif (L+, L-) et la terre,
- déterminer une résistance d'isolation totale (R) actuelle du système (2) d'alimentation électrique au moyen d'un contrôleur permanent d'isolement (10),
- vérifier si la résistance d'isolation totale (R) actuelle excède une valeur de seuil (Rₘᵢₙ), et signaler un dépassement.

4. Procédé selon la revendication 3,
**caractérisé en ce que**
la valeur de seuil (Rₗᵢₘ) de la résistance d'isolement totale est définie en fonction d'une valeur de résistance d'isolement spécifique au système d'alimentation électrique et en fonction de résistances (Rᵢₛₒ₁, Rᵢₛₒ₂) reliées à haute impédance.

5. Procédé selon la revendication 3 ou la revendication 4,
**caractérisé en ce que**
si la résistance d'isolement totale excède la valeur de seuil (Rₗᵢₘ), le système (2) d'alimentation électrique est déclenché.

6. Procédé pour la détection d'une interruption d'un conducteur actif (L+, L-) dans un système (2) d'alimentation électrique en tension continue non mis à la terre, le procédé comprenant les étapes suivantes :
- relier une résistance à haute impédance aussi proche que possible entre chaque conducteur actif (L+, L-) et la terre,
- déterminer une tension de déplacement (Uv) actuelle entre un point interconnecté de tous conducteurs actifs (L+, L-) et la terre,
- vérifier si la tension de déplacement (Uv) actuelle excède une valeur de seuil (Uvmax), et signaler un dépassement.

7. Procédé selon la revendication 6,
**caractérisé en ce que**
la valeur de seuil (U_{Vmax}) de la tension de déplacement est définie en fonction d'une valeur de résistance d'isolement spécifique au système d'alimentation électrique et en fonction de résistances reliées à haute impédance et en fonction d'une tension nominale (U_{N}) du système (2) d'alimentation électrique.

8. Procédé selon la revendication 6 ou la revendication 7,
**caractérisé en ce que**
la tension de déplacement (Uv) actuelle est déterminée et le système (2) d'alimentation électrique est déclenché au moyen d'un relais de tension si la tension de déplacement excède la valeur de seuil (U_{Vmax}).

9. Procédé selon la revendication 6 ou la revendication 7,
**caractérisé en ce que**
la tension de déplacement (Uv) actuelle est déterminée au moyen d'une fonction (30) de mesure de tension intégrée dans un contrôleur permanent d'isolement (10) et le système (2) d'alimentation électrique est déclenché au moyen d'un moyen de déclenchement si la tension de déplacement excède la valeur de seuil (U_{Vmax}).

10. Procédé pour la détection d'une interruption d'un conducteur actif (L+, L-) dans un système (2) d'alimentation électrique en tension continue non mis à la terre, le procédé comprenant les étapes suivantes :
- relier une capacitance (Cₑ₁, Cₑ₂) aussi proche que possible au consommateur entre chaque conducteur actif (L+, L-) et la terre,
- déterminer une capacitance totale (Cₑ) actuelle du système d'alimentation électrique,
- vérifier si la capacitance totale (Cₑ) actuelle reste inférieur à une valeur de seuil (Cₑₘᵢₙ), et signaler une infériorité.

11. Procédé selon la revendication 10,
**caractérisé en ce que**
la valeur de seuil (Cₑₘᵢₙ) de la capacitance totale est définie en fonction de capacitances de fuite spécifiques au système d'alimentation électrique et en fonction de capacitances (Cₑ₁, Cₑ₂) reliées.

12. Procédé selon la revendication 10 ou la revendication 11,
**caractérisé en ce que**
la capacitance totale (Cₑ) actuelle est déterminée au moyen d'un dispositif de mesure de capacitance et/ou au moyen d'un contrôleur permanent d'isolement ayant une fonction de mesure de capacitance intégrée.

13. Procédé selon l'une quelconque des revendications 10 à 12,
**caractérisé en ce que**
si la capacitance totale reste inférieure à la valeur de seuil (Cₑₘᵢₙ), le système (2) d'alimentation électrique est déclenché.

14. Procédé pour la détection d'une interruption d'un conducteur actif (L+, L-) dans un système (2) d'alimentation électrique en tension continue non mis à la terre, le procédé comprenant les étapes suivantes :
- relier une capacitance (Cₑ₁, Cₑ₂) aussi proche que possible au consommateur entre chaque conducteur actif (L+, L-) et la terre,
- déterminer une impédance totale (Zₑ) actuelle du système d'alimentation électrique,
- vérifier si l'impédance totale (Zₑ) actuelle excède une valeur de seuil (Zₗᵢₘ), et signaler un dépassement.

15. Procédé selon la revendication 14,
**caractérisé en ce que**
la valeur de seuil (Zₗᵢₘ) de l'impédance totale est définie en fonction d'une valeur de résistance d'isolement spécifique au système d'alimentation électrique et en fonction de capacitances de fuite spécifiques au système d'alimentation électrique et en fonction de capacitances (Cₑ₁, Cₑ₂) reliées.

16. Procédé selon la revendication 14 ou la revendication 15,
**caractérisé en ce que**
l'impédance totale (Zₑ) actuelle est déterminée au moyen d'un dispositif de mesure d'impédance et/ou au moyen d'un contrôleur permanent d'isolement (10) ayant une fonction de mesure d'impédance (50) intégrée.

17. Procédé selon l'une quelconque des revendications 14 à 16,
**caractérisé en ce que**
si l'impédance totale excède la valeur de seuil (Zₗᵢₘ), le système (2) d'alimentation électrique est déclenché.

18. Procédé pour la détection d'une interruption d'un conducteur actif (L+, L-) dans un système (2) d'alimentation électrique en tension continue non mis à la terre
**caractérisé en ce**
**qu'**au moins deux des procédés selon la revendications 1, 3, 6, 10 et 14 sont exécutés pour la détection redondante de l'interruption du conducteur actif (L+, L-).
